# EUROPÄISCHE PATENTSCHRIFT

(11) **EP 2 815 434 B1**
(45) Veröffentlichungstag und Bekanntmachung des Hinweises auf die Patenterteilung: **14.12.2016**
(21) Anmeldenummer: 13704136.4
(22) Anmeldetag: 15.02.2013
(51) Int. Cl.: H01L 31/042, H01L 31/02

(54) **ABSCHALTUNG VON SOLARMODULEN**
SWITCHING-OFF OF SOLAR MODULES
MISE HORS CIRCUIT DE MODULES SOLAIRES

(30) Priorität: 17.02.2012 EP 12155952
(43) Veröffentlichungstag der Anmeldung: 24.12.2014
(73) Patentinhaber: Multi-Holding AG, 4123 Allschwil (CH)
(72) Erfinder: VOLZ, Hubert, 45470 Mülheim (DE)
(74) Vertreter: Frischknecht, Harry Ralph
(86) Internationale Anmeldenummer: PCT/EP2013/053089
(87) Internationale Veröffentlichungsnummer: WO 2013/121003

(56) Entgegenhaltungen:
- WO-A2-2011/023732
- US-A1- 2010 139 734

## Beschreibung

### TECHNISCHES GEBIET

Die vorliegende Erfindung betrifft ein Verfahren zur sicheren Abschaltung eines Photovoltaikmoduls nach Anspruch 1, sowie eine entsprechende Vorrichtung nach Anspruch 8 und ein Photovoltaikmodul nach Anspruch 15.

### STAND DER TECHNIK

Photovoltaik-Module liefern bei Lichteinfall elektrische Energie, die standardmäßig nicht abgeschaltet werden kann und stellen bei Wartungs- und Löscharbeiten im Brandfall ein Sicherheitsrisiko dar.

Aus dem Stand der Technik sind Vorrichtungen bekannt, mit welchen sich das Photovoltaikmodul aus der Ferne manuell oder automatisch abschalten lässt. Solche Systeme haben aber den Nachteil, dass eine störsichere Kommunikation benötigt wird. Gerade bei einem Brand kann aber die Störsicherheit nicht gewährleistet werden.

Weiter haben besonders sichere Systeme den Nachteil, dass zusätzlich Steuerleitungen zu verlegen sind, was der Akzeptanz von diesen Systemen abträglich ist.

Die US 2010/139734 offenbart beispielsweise ein Verfahren zur sicheren Abschaltung eines Photovoltaikmoduls, wobei eine estes Sicherheitselement parallel über einen Solarzellgruppe angeordnet ist, und mit einem Scheltvorgang geschaltet wird, sodass über den solarzellgruppe ein kurzchluss kreis entsteht.

### DARSTELLUNG DER ERFINDUNG

Ausgehend von diesem Stand der Technik liegt der Erfindung eine Aufgabe zugrunde, ein Verfahren anzugeben, bei welchem das Photovoltaikmodul, insbesondere ohne zusätzliche Kommunikation oder Steuerleitungen auch im Brandfall in einen sicheren Modus bringbar ist bzw. abschaltbar ist.

Eine solche Aufgabe löst das Verfahren nach Anspruch 1. Demgemäss dient ein Verfahren zur sicheren Abschaltung eines Photovoltaikmoduls mit mindestens einer Solarzellgruppe, mit einem mit der mindestens einen Solarzellgruppe bzw. den Solarzellgruppen elektrisch in Verbindung stehenden ersten Leiter und mit einem mit der mindestens einen Solarzellgruppe bzw. den Solarzellgruppen elektrisch in Verbindung stehenden zweiten Leiter, wobei die besagten Leiter über eine Anschlussvorrichtung die von der Solarzellgruppe bzw. den Solarzellgruppen erzeugte Spannung aus dem Photovoltaikmodul wegführen. Eine Solarzellgruppe kann eine oder mehrere Solarzellen umfassen. Die Sicherheitsvorrichtung umfasst mindestens ein erstes Sicherheitsschaltelement und ein zweites Sicherheitsschaltelement, wobei die Sicherheitsschaltelemente parallel über der mindestens einen Solarzellgruppe oder über den Solarzellgruppen oder über eine Reihe von Solarzellgruppen angeordnet sind und mit dem ersten Leiter und dem zweiten Leiter elektrisch leitend in Verbindung stehen. Bei Eintritt eines Fehlerzustandes wird mindestens eines der Sicherheitsschaltelemente mit einem Schaltvorgang geschaltet, so dass über der Solarzellgruppe bzw. den Solarzellgruppen ein Kurzschlusskreis entsteht, wodurch die Solarzellgruppe bzw. die Solarzellgruppen von der Anschlussvorrichtung abgeschaltet werden. Die mindestens zwei Sicherheitsschaltelemente führen den Schaltvorgang in bezüglich der Temperatur mindestens teilweise unterschiedlichen Arbeitsbereichen aus. Die Arbeitsbereiche der mindestens zwei Sicherheitsschaltelemente sind teilweise überlappend.

Aufgrund der Tatsache, dass der Schaltvorgang bei unterschiedlichen Temperaturen ausgeführt wird, kann das Photovoltaikmodul bis zu hohen Temperaturen auch bei Ausfall von einem Sicherheitsschaltelement kurzgeschlossen werden. Weiter kann die Fehlersicherheit durch die Anordnung von mehreren Sicherheitsschaltelementen erhöht werden.

Der Fehlerzustand kann beispielsweise das Überschreiten einer vorbestimmten Temperatur sein, welche durch ein entsprechendes Element, wie einem temperaturgesteuerten Schalter erfasst wird.

Unter der Ausdrucksweise einer Reihe von Solarzellgruppen ist zu verstehen, dass mindestens zwei Solarzellgruppen in Reihe geschaltet sind und dass die Sicherheitsschaltelemente parallel zu dieser Gruppe liegen.

Selbstverständlich kann das Verfahren auf eine einzige Solarzellgruppe als auch auf mehrere in Reihe geschaltete Solarzellgruppen eingesetzt werden. Die Zahl der Solarzellgruppen kann beliebig sein.

Bezüglich der Temperatur ist jedem der Sicherheitsschaltelemente ein definierter Arbeitsbereich zugewiesen, wobei sich die Arbeitsbereiche teilweise überlappen.

Vorzugsweise führt das erste Sicherheitsschaltelement den Schaltvorgang bis zu einer vorbestimmten Temperatur aus und das zweite Sicherheitsschaltelement führt den Schaltvorgang über der vordefinierten Temperatur aus, wobei die vordefinierte Temperatur vorzugsweise im oberen Bereich des Arbeitsbereiches des ersten Sicherheitsschaltelementes liegt. Unter der Ausdrucksweise oberer Bereich wird beispielsweise ein Bereich von grösser als die mittlere Temperatur im entsprechenden Arbeitsbereich verstanden.

Vorzugsweise führen die Sicherheitsschaltelemente bis zum Erreichen einer vordefinierten Grenztemperatur den besagten Schaltvorgang reversibel aus, so dass bei Wegfall des Fehlerzustandes die Sicherheitsschaltelemente derart geschaltet werden, dass der besagte Kurzschlusskreis unterbrochen wird.

Vorzugsweise führt mindestens eines der Schaltelemente bei Überschreiten einer vordefinierten Grenztemperatur den Schaltvorgang irreversibel aus, so dass der Kurzschlusskreis auch nach dem Unterschreiten der Grenztemperatur besteht.

Vorzugweise weist mindestens eines der Sicherheitsschaltelemente die Gestalt eines Halbleiterschaltelementes auf und mindestens eines der Sicherheitsschaltelement weist die Gestalt eines elektromechanischen Relais auf, wobei unterhalb oder bis zu einer vorbestimmten Temperatur, welche bevorzugt unterhalb der maximalen Betriebstemperatur der Halbleiterschaltelemente liegt, der besagte Schaltvorgang von allen Sicherheitsschaltelementen gewährleistet wird, während oberhalb dieser maximalen Betriebstemperatur der Halbleiterschaltelemente bzw. der vorbestimmten Temperatur der besagte Schaltvorgang vom elektromechanischen Relais gewährleistet wird.

Vorzugsweise sind die Sicherheitsschaltelemente bezüglich der Schaltung nach unterschiedlichen physikalischen Prinzipien ausgebildet. Dies hat den Vorteil, dass die Ausfallsicherheit jeglichen Störfällen weiter verbessert werden kann.

Eine Sicherheitsvorrichtung zur Durchführung des Verfahrens umfasst mindestens ein erstes Sicherheitsschaltelement und ein zweites Sicherheitsschaltelement, wobei die Sicherheitsschaltelemente parallel über der mindestens einen Solarzellgruppe bzw. den Solarzellgruppen angeordnet sind und mit dem ersten Leiter und dem zweiten Leiter elektrisch leitend in Verbindung stehen, wobei bei Eintritt eines Fehlerzustandes mindestens eines der Sicherheitsschaltelemente mit einem Schaltvorgang geschaltet wird, so dass über der mindestens einen Solarzellgruppe bzw. den Solarzellgruppen ein Kurzschlusskreis herstellbar ist, wobei der Schaltvorgang durch die mindestens zwei Sicherheitsschaltelemente in bezüglich der Temperatur mindestens teilweise unterschiedlichen Arbeitsbereichen ausführbar sind.

Vorzugsweise ist die Sicherheitsvorrichtung in einer Anschlussdose, die an einem Photovoltaikmodul angeordnet werden kann aufgenommen.

Weitere Ausführungsformen sind in den abhängigen Ansprüchen angegeben.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine elektrisches Schaltbild einer Sicherheitsvorrichtung zur sicheren Abschaltung eines Photovoltaikmoduls nach einer Ausführungsform der vorliegenden Erfindung; und
- Fig. 2: eine schematische Darstellung von verschiedenen Arbeitsbereichen von Sicherheitsschaltelementen, welche in der Sicherheitsvorrichtung nach der Figur 1 eingesetzt werden können.

### BESCHREIBUNG BEVORZUGTER AUSFÜHRUNGSFORMEN

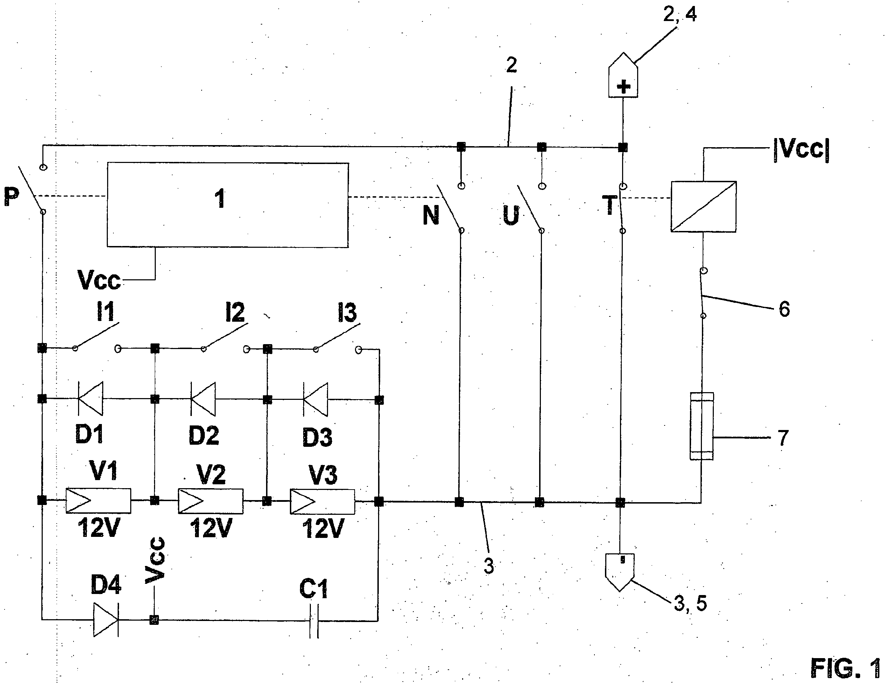

Die Figur 1 zeigt ein elektrisches Schaltbild einer Sicherheitsvorrichtung zur sicheren Abschaltung eines Photovoltaikmoduls nach einer Ausführungsform der vorliegenden Erfindung. Diese in Figur 1 gezeigte Sicherheitsvorrichtung kann nach einem erfindungsgemässen Verfahren betrieben werden. Es ist aber anzumerken, dass das untenstehend beschriebene erfindungsgemässe Verfahren auch mit anderen Sicherheitsvorrichtungen ausgeführt werden kann.

In der vorliegenden Ausführungsform umfasst das Photovoltaikmodul mindestens eine Solarzellgruppe V1. Hier sind drei Solarzellgruppen V1, V2 und V3 angeordnet. Die Anzahl der angeordneten Solarzellgruppen ist aber für die Erfindung nicht relevant. Über jeder der Solarzellgruppen V1, V2, V3 befindet sich jeweils eine parallel zur jeweiligen Solarzellgruppe V1, V2, V3 angeordnete Bypassdiode oder Freilaufdiode D1, D2, D3. Parallel zur jeweiligen Solarzellgruppe V1, V2, V3 bzw. zur jeweiligen Bypassdiode D1, D2, D3ist weiter jeweils ein Schaltelement I1, 12, 13 angeordnet. Bypassdiode D1, D2, D3und Schaltelement I1, 12, 13 dienen der Ausserbetriebnahme von einzelnen Solarzellgruppen bei einer Störung.

Weiter umfasst die Sicherheitsvorrichtung eine Steuerung 1, welche mit einer Hilfsspannung Vcc versorgt wird. Die Steuerung 1 dient im Wesentlichen der Steuerung der beiden Schalter P und N im Normalbetrieb, so wie dies unten erläutert wird. Die Hilfsspannung Vcc wird vorzugsweise mit mindestens einer der Solarzellgruppen V1, V2, V3 und der Diode D4 sowie dem Kondensator C1 selbst erzeugt.

In der bevorzugten Ausführungsform der Spannungsversorgung reduziert der Schalter P zum Erhalt der internen Spannung Vcc den durch den Kurzschlußkreis (U, T) fliessenden Kurzschlußstrom und kann ihn auch bei geeigneter Ansteuerung durch den Steuerkreis 1 vollständig abschalten. Dadurch ist das Solarmodul sowohl nach aussen kurzgeschlossen als auch intern unterbrochen. Der Schalter P ist zur Erhaltung der Spannungsversorgung Vcc bei einigen Betriebsarten des Moduls vorteilhaft, es sei denn Vcc wir anderweitig erzeugt.

Die Schaltung bzw. das Photovoltaikmodul umfasst weiter einen mit den Solarzellgruppen elektrisch in Verbindung stehenden ersten Leiter 2 und einen mit den Solarzellgruppen elektrisch leitend in Verbindung stehenden zweiten Leiter 3. Die besagten Leiter 2, 3 führen über eine Anschlussvorrichtung 4, 5 die von den Solarzellgruppen V1, V2, V2 erzeugte Spannung aus dem Photovoltaikmodul weg. Folglich stehen der erste Leiter 2 und der zweite Leiter 3 über eine Anschlussvorrichtung mit elektrischen Verbrauchern in Verbindung. Die beiden Leiter 2, 3 können über Anschlüsse 4 und 5 mit externen elektrisch leitenden Elementen, wie mit einem Kabel, das zum Netz bzw. zu den Verbrauchern führt, kontaktiert werden. Der erste Leiter 2 stellt hier den Pluspol und der zweite Leiter 3 den Minuspol dar.

Die Sicherheitsschaltung umfasst mindestens ein erstes Sicherheitsschaltelement und ein zweites Sicherheitsschaltelement. In der vorliegenden Ausführungsform stellt der Schalter U das erste Sicherheitsschaltelement und der Schalter T das zweite Sicherheitsschaltelement dar. Die Sicherheitsschaltelemente U, T sind parallel über den Solarzellgruppen V1, V2, V3 angeordnet und stehen mit dem ersten Leiter 2 und dem zweiten Leiter 3 elektrisch leitend in Verbindung. Mindestens eines dieser Schaltelemente wird im Fehlerzustand geschaltet, so dass über den Solarzellgruppen V1, V2, V3 ein Kurzschlusskreis entsteht, wodurch die besagten Anschlüsse 4 und 5 sowie die mit den Anschlüssen in Verbindung stehenden externen elektrisch leitenden Elemente nicht mehr mit elektrischer Energie versorgt werden, wodurch das Photovoltaikmodul in einem sicheren Zustand ist.

Durch die Anordnung von mindestens zwei Sicherheitsschaltelementen U, T sind die Sicherheitsvorrichtungen mehrfach vorhanden und bei Ausfall eines der sicherheitsrelevanten Sicherheitsschaltelemente U, T übernehmen andere Sicherheitsschaltelemente die Aufgabe des sicheren Abschaltens der Solarzellgruppen V1, V2, V3. Wenn nun also das Sicherheitsschaltelement U ausfällt, so kann das Sicherheitsschaltelement T die Schaltung übernehmen.

Die Sicherheitsschaltung nach der Figur 1 ist im Bereich des Photovoltaikmoduls angeordnet. Vorzugsweise ist die Sicherheitsschaltung in einer Anschlussdose oder aber direkt im Photovoltaikmodul selbst, also beispielsweise in einem Rahmen des Photovoltaikmoduls, angeordnet sein. Folglich bestehen also keine sicherheitsrelevanten Steuerleitungen zu vom Photovoltaikmodul entfernten Orten.

Mit der Schaltung bzw. der Sicherheitsschaltung nach der Figur 1 lässt sich das Photovoltaikmodul verschiedenartig steuern. Grundsätzlich wird zwischen dem Normalbetrieb und dem Notfallbetrieb bei Vorliegen eines Fehlerzustandes unterschieden.

Unter der Ausdrucksweise Normalbetrieb wird der normale Betrieb zur Erzeugung von elektrischer Energie verstanden. Üblicherweise befindet sich das Photovoltaikmodul in einem Temperaturbereich von -50°C bis 85°C im Normalbetrieb. Die Temperatur kann aber auch höher sein, beispielsweise bis 175°C Der Temperaturbereich liegt dabei im Wesentlichen innerhalb des erlaubten Betriebstemperaturbereiches der in der Sicherheitsschaltung vorhandenen elektronischen Bauteile. Bezüglich der Temperatur sei hier angemerkt, dass es sich um die Temperatur im Bereich der Sicherheitsschaltung also im Bereich des Photovoltaikmoduls handelt.

Der Normalbetrieb geht in einen Notfallbetrieb bzw. Störbetrieb über, sobald Fehlerzustände bzw. spezielle Umstände, wie beispielsweise ein Brand oder eine Hitzentwicklung im Bereich des Photovoltaikmoduls bzw. der Steuerung dies erfordern. Der Notfallbetrieb bzw. der Fehlerzustand tritt üblicherweise dann ein, bevor bzw. wenn die besagte Temperatur die erlaubte Betriebstemperatur der Elektronik überschreitet. Überschreitet die Betriebstemperatur die Maximaltemperatur der Elektronik, so wird durch ein bezüglich der Temperatur ausreichend bemessenes Sicherheitsschaltelement T das Modul bis zur Zerstörung bei Überschreiten einer Maximaltemperatur in einem kurzgeschlossenen Zustand gehalten. Unter der Ausdrucksweise Selbstzerstörung wird hierin verstanden, dass das Modul aufgrund von der Hitzeeinwirkung im Brandfall entsprechend zerstört wird, wobei es beispielsweise zum Glasbruch oder zum Auflöten der Zellverbinder kommen kann.

Im Störbetrieb bzw. im Notfallbetrieb, also bei Eintritt eines Fehlerzustandes, wird mindestens eines der Sicherheitsschaltelemente U, T geschaltet, so dass über den Solarzellgruppen V1, V2, V3 ein Kurzschlusskreis entsteht. Die mindestens zwei Sicherheitsschaltelemente U, T führen den Schaltvorgang in bezüglich der Temperatur unterschiedlichen Arbeitsbereichen aus.

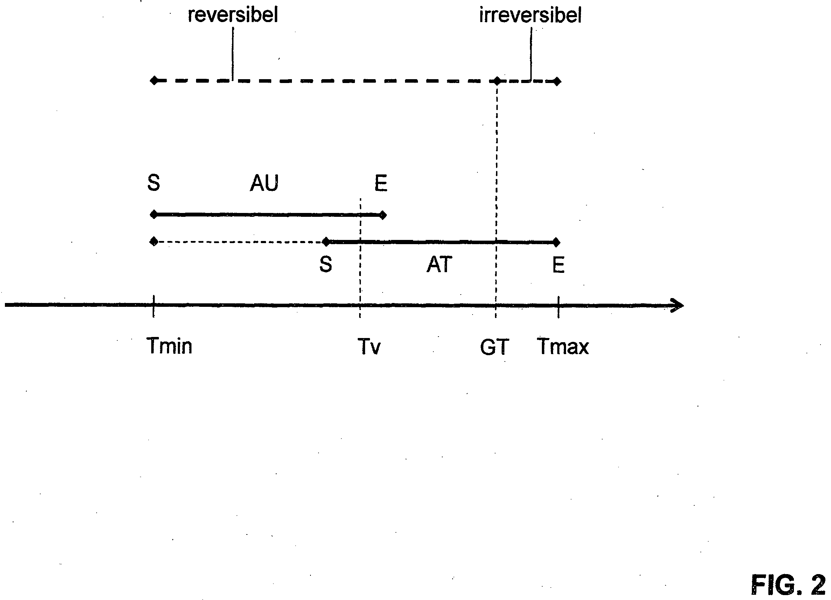

In der Figur 2 wird gezeigt, dass jedes der Sicherheitsschaltelemente U, T bezüglich der Temperatur einen dem Schaltelement zugewiesenen Arbeitsbereich aufweist. Dem Sicherheitsschaltelement U ist ein Arbeitsbereich AU und dem Sicherheitsschaltelement T ist ein Arbeitsbereich AT zugewiesen. Jeder der Arbeitsbereich AU und AT weist dabei einen Startpunkt S und einen Endpunkt E auf. Die Arbeitsbereiche AU und AT sind dabei derart gewählt, dass diese sich von einer vordefinierten minimalen Temperatur Tₘᵢₙ bis hin zu einer vordefinierten maximalen Temperatur Tₘₐₓ erstrecken. Folglich liegt der Startpunkt S des Arbeitsbereiches AU im Bereich der minimalen Temperatur Tₘᵢₙ und der Endpunkt E des Arbeitsbereiches AT im Bereich der maximalen Temperatur Tₘₐₓ.

Die Sicherheitsschaltelemente U, T sind dabei derart ausgebildet, dass über den gesamten Temperaturbereich von einer minimalen Temperatur Tₘᵢₙ bis hin zu einer maximalen Temperatur Tₘₐₓ mindestens eines der Sicherheitsschaltelemente U, T einen entsprechenden Arbeitsbereich AU, AT aufweist.

Die Arbeitsbereich AU und AT sind vorzugsweise derart, dass sich diese teilweise überlappen. Somit wird sichergestellt, dass bei jeder Temperatur immer mindestens eines der Schaltelemente P, N, U, T in seinem Arbeitsbereich ist. In diesem überlappenden Bereich ist somit eine gewisse Redundanz zwischen den Sicherheitsschaltelemente P, N, U, T vorhanden. Der Arbeitsbereich vom Schalter T kann sich aber auch über den gesamten Einsatzbereich, also von T_{Min} bis T_{Max} erstrecken. Der Schalter T ist vorzugsweise als elektromechanisches Relais ausgeführt, weil dessen obere Betriebstemperatur oberhalb der oberen Betriebstemperatur von Halbleiterschaltern liegt. Andere Schaltelemente für den Einsatz als Schalter T sind aber auch denkbar.

Mit anderen Worten kann auch gesagt werden, dass unterhalb einer vorbestimmten Temperatur Tv, die Sicherheit bzw. die Schaltung des Kurzschlusses von allen Sicherheitsschaltelementen P, N, U, T gewährleistet wird, während oberhalb dieser vorbestimmten Temperatur Tv, die bevorzugt unterhalb der maximalen Betriebstemperatur der Halbleiter liegt, die Sicherheit bzw. die Schaltung des Kurzschlusses nur von einem oder mehreren bestimmten anderen Sicherheitsschaltelement(en) T gewährleistet wird.

Diese vorbestimmte Temperatur Tv liegt bevorzugt bei etwa 85°C, also noch im Bereich der Betriebstemperatur der Elektronik. Die vorbestimmte Temperatur Tv kann aber auch höher oder tiefer liegen.

Vorzugsweise führt eines der Sicherheitsschaltelemente, hier das Sicherheitsschaltelement T bzw. das zweite Sicherheitsschaltelement T, bei Überschreiten einer vordefinierten Temperatur Tv den Schaltvorgang aus. Vorzugsweise liegt die vordefinierte Temperatur Tv im Arbeitsbereich der anderen Schaltelemente P, N und U. Bei einem Brandfall, also im Störbetrieb, kann somit die Situation eintreten, dass aufgrund der Hitzeeinwirkung des Feuers das eine Sicherheitsschaltelement U nicht mehr funktioniert, da die Temperatur schon über dem Arbeitsbereich AU des entsprechenden Sicherheitsschaltelementes U ist. Somit wird durch die Anordnung des zusätzlichen Sicherheitselementes T der maximal abzudeckende Temperaturbereich erhöht, wodurch auch bei hohen anliegenden Temperaturen das Photovoltaikmodul noch sicher abgeschaltet werden kann.

Das Sicherheitsschaltelement U weist in der vorliegenden Ausführungsform die Gestalt eines Halbleiterschaltelementes U auf. Das andere Sicherheitsschaltelement T weist hier die Gestalt eines elektromechanischen Relais T auf. Die beiden Sicherheitsschaltelemente U, T sind hier parallel zueinander angeordnet. Es können auch zwei Halbleiterschaltelemente N und U parallel zueinander angeordnet werden. Unterhalb oder bis zu einer vorbestimmten Temperatur Tv, welche unterhalb der maximalen Betriebstemperatur der Halbleiterschaltelemente U liegt, wird der besagte Schaltvorgang bevorzugt von allen Sicherheitsschaltelementen P, N, U, T gewährleistet. Oberhalb dieser maximalen Betriebstemperatur der Halbleiterschaltelemente U wird der besagte Schaltvorgang vom elektromechanischen Relais T gewährleistet. Folglich erstreckt sich der Arbeitsbereich AU des Halbleiterschaltelementes vom unteren Endpunkt bis hin zu dieser maximalen Betriebstemperatur und der Arbeitsbereich AT des Relais T erstreckt sich vom unteren Endpunkt bis zu einer maximalen Temperatur Tmax, welche über der maximalen Betriebstemperatur der Halbleiterschaltelemente U liegt. Die vorbestimmte Temperatur Tv, ab welcher der Schaltvorgang durch das Relais gewährleistet wird, liegt also vorzugsweise im Arbeitsbereich AU der Halbleiterschaltelemente.

Das Sicherheitsschaltelement T ist vorzugweise als Öffner ausgebildet, so dass es im Ruhezustand im geschlossenen Zustand verharrt und somit den Kurzschluss über dem Photovoltaikmodul bereitstellt. Somit kann das Solarmodul nur dann angeschaltet werden, wenn mindestens das Sicherheitsschaltelement T einsatzfähig ist. Folglich kann die Betriebssicherheit hier weiter erhöht werden.

In der Folge werden die Funktionen der Sicherheitsschaltelemente U, T genauer anhand des Halbleiterschaltelementes U und des elektromechanischen Relais T erläutert. In diesem Zusammenhang sei darauf hingewiesen, dass es sich beim Halbleiterschaltelement U und dem elektromechanischen Relais T um vorteilhafte Ausführungsformen handelt. Es können aber auch andere Sicherheitsschaltelemente mit ähnlichen Funktionen und Eigenschaften eingesetzt werden. Wichtig ist aber, dass die beiden Sicherheitsschaltelemente Arbeitsbereiche über unterschiedliche Temperaturen aufweisen.

Vorzugweise sind die Sicherheitsschaltelemente bezüglich der Schaltung nach unterschiedlichen physikalischen Prinzipien ausgebildet. Beispielsweise führt das Sicherheitsschaltelement U in der Gestalt eines Halbleiterschaltelementes den Schaltvorgang in einem Temperaturbereich bzw. Arbeitsbereich von -40°C bis 100°C aus. Die oben genannte vorbestimmte Temperatur Tv liegt bevorzugt in einem Bereich von 60°C bis 100°C, insbesondere in einem Bereich von 60°C bis 85°C. Das Sicherheitsschaltelement T in der Gestalt eines elektromechanischen Relais hingegen führt den Schaltvorgang in einem Temperaturbereich bzw. einem Arbeitsbereich von -50°C bis zu einem Bereich von 300°c bis 500°C, bevorzugt 450°C, aus. Folglich kann also mit der Anordnung von mindestens zwei Sicherheitsschaltelementen, welche bezüglich der Temperatur unterschiedliche Arbeitsbereiche aufweisen eine erhöhte Sicherheit geschaffen werden. Insbesondere aber kann eine Sicherheitsschaltung angeben werden, welche auch im Brandfall das Photovoltaikmodul sicher kurzschliesst, so dass keine Gefahren bezüglich eines Stromschlages vom Photovoltaikmodul ausgehen.

Mit anderen Worten kann auch gesagt werden, dass das Schutzkonzept aus einer Kombination verschiedener elektronischen und elektromechanischen Schalter, die die Sicherheit durch die Verwendung von verschiedenen physikalischen Prinzipien und deren mehrfachen Verwendung erhöht. Folglich wird die Anlagensicherheit insgesamt erhöht.

Besonders bevorzugt sind mindestens ein elektromechanisches Relais und mehrere Halbleiterschalter als Sicherheitsschaltelemente vorhanden.

Das Sicherheitsschaltelement U in der Gestalt des Halbleiterschalters kann verschiedenartig angesteuert werden. Das Sicherheitsschaltelement U kann beispielsweise wie unten beschrieben bei einer Überspannung ausgelöst werden. Das Sicherheitsschaltelement U kann beispielsweise analog einer Phasenanschnittsteuerung angesteuert werden.

Das elektromechanische Relais T kann verschiedenartig angesteuert werden. Das elektromechanische Relais T wird hier über eine Hilfsspannung Vcc versorgt und offen gehalten. Sobald die Hilfsspannung Vcc abfällt, schliesst der Schalter T, so dass das Photovoltaikmodul bzw. die Solarzellgruppen V1, V2, V3 entsprechend kurzgeschlossen wird. In der Ausgangsstellung ist das elektromechanische Relais T also im geschlossen Zustand, wodurch die Erzeugung der Hilfsspannung nicht sicherheitsrelevant ist. Bei Anlegen der Hilfsspannung öffnet das Relais T und der Kurzschluss über dem Modul wird aufgebhoben. Fehlt die Hilfsspannung Vcc so fällt das elektromechanische Relais ab und das Photovoltaikmodul ist im sicheren Zustand kurzgeschlossen. Das hierin beschriebene Sicherheitskonzept ermöglicht, dass bei Überhitzung, bei einem Ausfall der Steuerelektronik oder der Leistungshalbleiter oder einem internen Lichtbogen in der Anschlussdose oder einer beliebigen Fehlfunktion der elektronischen Steuerung 1 das Modul kurzgeschlossen und damit sicher ist.

Im vorliegenden Ausführungsbeispiel ist zudem ein temperaturgesteuerter Hilfsschalter 6 vorgesehen, welcher das elektromechanische Relais T entsprechend steuert. Sobald die Temperatur im Bereich des Hilfsschalters 6 über die besagte vordefinierte Temperatur Tv ansteigt, öffnet sich der Hilfsschalter 6, wodurch das vor dem Öffnen des Hilfsschalters 6 mit der Hilfsspannurlg Vcc beaufschlagte elektromechanische Relais T ebenfalls schliesst. Sobald dann die Temperatur wieder unter die Temperatur Tv absinkt, so schliesst sich der Hilfsschalter 6 wieder, wodurch sich das elektromechanische Relais T wieder öffnet. Es wird also somit ein reversibler Schaltvorgang ermöglicht.

Der Hilfsschalter 6 ist beispielsweise ein Kaltleiter oder ein Werkstoff im magnetischen Kern des Relais, der bei Erreichen der Curietemperatur das Relais abfallen lässt. Die Curietemperatur entspricht dabei im Wesentlichen der vorbestimmten Temperatur Tv.

Weiter kann die Sicherheitsvorrichtung zusätzlich eine optionale Temperatursicherung 7 umfassen. Die Temperatursicherung 7 ist dabei in Serie zum Hilfsschalter 6 angeordnet. Die Temperatursicherung 7 dient im Wesentlichen zur irreversiblen Abschaltung des Photovoltaikmoduls, sobald die auf das Photovoltaikmodul einwirkende Temperatur eine vorbestimmte Grenztemperatur GT überschritten ist. Die Grenztemperatur GT kann beispielsweise bei kleiner als 130°C liegen. Sobald nun also die einwirkende Temperatur 130°C überschritten hat, so wird die Temperatursicherung 7 zerstört. Somit wird das elektromechanische Relais T nicht mehr mit der Hilfsspannung Vcc versorgt, wodurch das Relais T entsprechend schliesst und die Solarzellgruppen kurzschliesst. Auch nach einem Unterschreiten der Grenztemperatur GT verharrt das Sicherheitsschaltelement 6 in der geschlossenen Position, also im leitenden Zustand, wodurch der Kurzschluss weiter anhält. Die Anlage kann ohne fachmännische Wartung nicht mehr direkt in Betrieb gehen.

Durch dieses Sicherheitskonzept mit dem temperaturgesteuerten Hilfsschalter 6 und der optionalen Temperatursicherung 7 wird also sichergestellt, dass bei einem Versagen der Steuerungselektronik, insbesondere der Halbleiterschalter P, N, U, das Photovoltaikmodul sicher abgeschaltet werden kann, wobei die Abschaltung nach Überschreiten einer vorbestimmten Temperatur Tv erfolgt. Die Schalter P, N, U können auch als Trennvorrichtungen bezeichnet werden. Die Abschaltung erfolgt bis zu einer bestimmten Grenztemperatur GT reversibel und bei Überschreiten der Grenztemperatur irreversibel.

Der Ruhezustand des Sicherheitsschaltelementes T ist geschlossen. Folglich wird bei Anlegen der Hilfsspannung Vcc das Sicherheitsschaltelement T geöffnet und bei Wegfallen der Hilfsspannung Vcc entsprechend wieder geschlossen. Die Hilfsspannung Vcc kann aus verschiedenen Gründen wegfallen, beispielsweise durch einen Ausfall der Steuerung, durch Öffnen des Temperaturschalters 6 oder durch Ausfall der Temperatursicherung 7.

Das Sicherheitsschaltelement U kann beispielsweise als bei einer Überspannung auslösender Schalter ausgebildet sein. Ein solcher Schalter schützt die Sicherheitsschaltung sowohl vor Überspannung als auch das Solarmodul vor unzulässig hohen Rückströmen und internen Lichtbögen z.B. durch Verbinderbruch. Bei einem internen Lichtbogen steigt die Modulspannung um ca. 12V und liegt damit oberhalb der Leerlaufspannung. Auch ein hoher Rückstrom erhöht die Modulspannung über die Leerlaufspannung und kann daher in gleicher Weise ausgewertet werden. Die vorzugsweise Ausführung des Schalters U ist ein Triac oder ein Thyristor. Wird der Schalter U leitend, dann bleibt er leitend und verhält sich dadurch wie ein Relais mit Selbsthaltung. Falls der Schalter U zu heiss wird, dann schützt der Sicherheitsschalter T den Schalter U und fährt das Modul in den sicheren Kurzschlusszustand wie oben beschrieben. Die Temperatur des Schalters U wird durch den Hilfsschalter 6 entsprechend überwacht bzw. erfasst, wobei einem Überschreiten der besagten vorbestimmten Temperatur Tv der Hilfsschalter 6 entsprechend schaltet und somit das Relais T schliesst.

Mit der hierin gezeigten Schaltung kann das Photovoltaikmodul insbesondere in folgenden Betriebsmodi betrieben werden:

### Bypassbetrieb bei Vollverschattung

Wenn der Schalter P den Strom trennt, dann muss ein Bypass für den Strom anderer Module geschaffen werden. Der Schalter P trennt den Strom, so dass die Hilfsspannung Vcc erhalten bleibt. Dazu dient zum einen der Schalter N der vorzugsweise als N-MOSFET ausgeführt ist. Selbst bei fehlender Ansteuerung würde dieser Halbleiterschalter dann den Bypassstrom durchlassen. Falls der Schalter N unterbrochen ist, dann wird der spannungsgetriggerte Schalter U leitend, der hierzu in der Ausführung TRIAC ist. Sollte auch der Schalter U ausfallen, übernimmt der Schalter T.

### Bypassbetrieb bei Teilverschattung

Ist das Modul nur teilverschattet, so bleibt der Schalter P leitend und der Schalter N gesperrt. Da intern eine Hilfsspannung Vcc erzeugt wird, bietet es sich an die Bypassdioden mit stromrichtungsgesteuerten Schaltern I1, I2, I3 zu überbrücken. Dadurch sinkt die Temperatur in der Anschlussdose und steigt die Stromernte durch Reduzierung der Diodendurchlassverluste.

### Sicheres Einschalten

Zum Starten kann von ausserhalb des Photovoltaikmoduls ein Gleich- oder alternativ ein Wechselstrom auf die Anschlüsse "Plus" und "Minus" gegeben werden. Nur wenn wie Anlage vorher frei von Gleichstrom war, wird bei funktionierender Steuerelektronik (Selbsttest der Steuerelektronik, der Leistungshalbleiter und der Bypassdioden) der Kurzschluss durch Schalter T aufgehoben und die Schalter U, N und P von der Steuerelektronik leitend geschaltet. Durch den Start im spannungslosen Zustand werden die Relaiskontakte geschont und sichergestellt, dass die für die Startsequenz benötigte Wechselspannung nicht von einem Lichtbogen oder fehlerhaften Wechselrichter herrührt.

Zusätzlich ist ein Modulstart auch durch ein Kommunikationssignal möglich, da die Steuerelektronik in jeder Betriebsart entsprechend ausgerüstet ist.

### Aktiver PV-Modulschutz

Durch die Selbstauslösung des Schalters U bei Überspannung besteht ein gewisser Überspannungsschutz für die Schaltung, den Solarzellgruppen und auch für die Bypassdioden D1, D2, D3.

Die Solarzellgruppen können sowohl im Bypassbetrieb als auch im Rückstrombetrieb durch die drei Kurzschlußkanäle N, U und T elektrisch entlastet oder abgeschaltet werden. Dadurch gibt es erstmals einen aktiven Selbstschutz für Solarzellgruppen, der auch durch eine Übertemperatur des Moduls angestossen werden kann.

### Normalbetrieb

Im Normalbetrieb ist der Schalter P leitend, also geschlossen, und die restlichen Schalter N, U und T sind nicht-leitend, also geöffnet.

### Rückstrombetrieb

Im Rückstrombetrieb sind die Schalter N, U und T nicht-leitend, also geöffnet. Bei der vorzugsweisen Ausführung von Schalter P als P-MOSFET spielt es keine Rolle, ob Schalter P geöffnet oder leitend ist, da die in diesem Halbleiterschalter integrierte Bodydiode leitend wird. Ein zusätzliches Ansteuern von Schalter P reduziert die Abwärme von Schalter P. Bei grossem Überstrom kann der Strom über Schalter N oder in schwerwiegenden Fällen über Schalter U umgeleitet werden, was einem aktiven Photovoltaikmodulschutz gleichkommt. Falls die Schalter P, N, U zu heiss werden, dann übernimmt wiederum der Sicherheitsschalter T.

### Bypassbetrieb

Im Bypassbetrieb sind Schalter U und T nicht-leitend, also geöffnet. Wahlweise kann der Bypassstrom über Schalter P oder auch über Schalter N fliessen. Bei großem Überstrom kann Schalter U gezündet werden, was bei sehr großem Überstrom automatisch erfolgt.

### Funktion der Bypassdioden

Die Bypassdioden D1, D2, D3können bei entsprechender Ansteuerung von Schalter P und N entfallen. Die Stromernte wird durch zusätzliche Bypassdioden jedoch größer. Die Bauelemente I1, I2, I3 können im einfachsten Fall als Dioden, als MOSFET-Schalter (funktional wie eine Smart Bypassdiode) oder in Verbindung mit geschalteten komplexen Widerständen als Ladungspumpe oder Schaltnetzteil ausgeführt sein.

Der Einsatz von MOSFETs bietet sich an, da für die Ansteuerung von Schalter N sowieso eine Hilfsspannung erzeugt werden muss, die dann auch für die Ansteuerung von D1, D2, D3verwendbar wäre. Diese Lösung ist in Summe kostengünstiger als die Verwendung spezieller auf dem Markt erhältlichen "Cool Bypass Switch" oder "Smart Bypass Diodes", weil diese Bauteile separat für sich die Hilfsspannung intern erzeugen müssen, während die oben beschriebene Schaltung ununterbrochen arbeiten würde.

### Hardware Selbsttest

Das Photovoltaikmodul ist im Ruhezustand unterbrochen und die Anschlüsse 2 (Pluspol) und 3 (Minuspol) über das Sicherheitsschaltelement T kurzgeschlossen. Durch die Art der Schaltung wird sichergestellt, dass die sicherheitsrelevanten Bauteile der Steuerelektronik und die Leistungshalbleiter P, N, U ordnungsgemäß funktionieren müssen, bevor das Photovoltaikmodul Spannung nach aussen abgibt. Weiter kann auch die Funktion der Bypassdioden D1, D2, D3 von der Schaltung getestet werden, was dann über das übliche PV-Modulmonitoring hinausgeht.

### Monitoring

Da Temperatur, Ströme und Spannungen von der Steuerelektronik erfasst werden, kann die Modulspannung, Modulstrom und Modultemperatur über einen Kommunikationskanal weitergeleitet werden.

### Vorzugsweise Kommunikation im Normalbetrieb

Die Kommunikation kann beispielsweise wie folgt ausgeführt werden:
Senden
   a) Durch einen Nebenstrom über MOSFET N
   b) Durch eine Strombegrenzung über MOSFET P
Empfang
   a) Durch Abfragen des Modulstroms über Stromfühlerwiderstände
   b) Durch Abfragen der Modulspannung Uo

### Vorzugsweise Kommunikation im Kurzschlußbetrieb

Vorsichtsmaßnahme: Schalter U zur Spannungsbegrenzung zünden und Relais T(2) öffnen Senden
a) Durch einen Nebenstrom über MOSFET N
b) Durch eine Strombegrenzung über MOSFET P
Empfang
a) Durch Abfragen des Modulstroms über Stromfühlerwiderstände
b) Durch Abfragen der Modulspannung Uo

### Abschaltung des gesamten PV-Generators durch eine Fehlermeldüng in einem einzelnen PV-Modul

Bei einem lokalen Brand in einer ausgedehnten Solaranlage sind zunächst nur wenige Solarmodule überhitzt. Zur Löschung der Anlage ist es aber notwendig, dass die gesamte Anlage spannungsfrei geschaltet wird. Das überhitze Modul wird abschalten und verursacht auf der Stringleitung einen schnellen und starken Abfall der Stringspanung. Dieser Spannungsabfall kann als Triggersignal für die Abschaltung aller restlichen Module benutzt werden. Natürlich kann der Abschaltbefehl auch über ein Kommunikationssignal erfolgen, welches durch die abschaltende Sicherheitseinrichtung oder ein anderes Gerät der PV-Anlage in diesem Fall abgesetzt wird.

### Lichtbogenerkennung

Durch die Überwachungsmöglichkeit von Wechselsignalen sowohl der Modulspannung als auch des Modulstroms ist es im Prinzip möglich eine Lichtbogenerkennung zu implementieren. Insbesondere bei der Verwendung eines Mikroprozessors in der Steuerelektronik kann eine Hardware-Lichtbogenerkennung als eine Softwareroutine ersetzt werden. Modulinterne oder Anschlußdoseninterne Lichtbögen werden durch die Schaltung erkannt und gelöscht. Folgende Prinzipien sind denkbar:
1. Detektion durch AC-Schwingungen
2. Spannungsanstieg in der Modulspannung
3. Temperaturanstieg in der Anschlußdose
4. Die Summe der Modulspannungen muss gleich der Stringspannung sein.

### Optional: Polwender

Gewöhnlich sind die Solarzellgruppen eines Moduls fest in Reihe geschaltet. Wenn die Solarzellgruppen eines Moduls voneinander galvanisch getrennt und in gleicher Anzahl herausgeführt werden, dann gibt es folgende zusätzlich Betriebsarten:
- Antiseriellschaltung der Solarzellgruppen. Dadurch sinkt die Modulspannung auf Null Volt und die Strombelastung der Sicherheitsschalter T, U, sowie der Halbleiterschalter wird stark reduziert
- Antiparallelschaltung beider Solarzellgruppengruppen. Das entspricht einem Modulkurzschluss mit der Ausgangsspannung Null. Auch hier wird die Strombelastung der Sicherheitsschalter erheblich reduziert.
- Parallelschaltung beider Solarzellgruppengruppen mit halber maximaler Ausgangsspannung entweder in Plus- oder Minusrichtung.
- Reihenschaltung aller Solarzellgruppen entweder in Plus- oder Miriusrichtung mit maximaler Ausgangsspannung.
- Durch eine geeignete zeitliche Abfolge der Betriebszustände, ist das PV-Modul nun in der Lage Wechselstrom zu liefern. Dieser reduziert die Gefahr von Lichtbögen in der Anlage und kann bei Inselanwendungen direkt einen Trafo ansteuern. Dieser Wechselstrom ist nicht sinusförmig, aber für einfache Anwendungen ausreichend. Für den Wechselstrombetrieb müsste die oben beschriebene Schaltung modifziert werden.

Bei der Parallelschaltung von den Solarzellgruppengruppen V1 bis V3 kann bei Teilverschattung der Modulstrom so weit erhöht werden, dass die Bypassdioden weitaus weniger belastet oder sogar funktional überflüssig werden.

**BEZUGSZEICHENLISTE**

| | | | |
|---|---|---|---|
| 1 | Steuerelektronik | Vcc | Hilfsspannung |
| 2 | erster Leiter | | |
| 3 | zweiter Leiter | | |
| 4 | Anschlüsse | | |
| 5 | Anschlüsse | | |
| 6 | Temperaturgesteuerter Hilfsschalter | | |
| 7 | Temperatursicherung | | |
| V1 | Solarzellgruppe | | |
| V2 | Solarzellgruppe | | |
| V3 | Solarzellgruppe | | |
| D 1 | Bypassdioden | | |
| D2 | Bypassdioden | | |
| D3 | Bypassdioden | | |
| I1 | Halbleiterschalter | | |
| 12 | Halbleiterschalter | | |
| I3 | Halbleiterschalter | | |
| N | Halbleiterschalter | | |
| U | Halbleiterschalter | | |
| T | Temperaturgesteuerter Schalter | | |
| P | Halbleiterschalter | | |

## Patentansprüche

1. Verfahren zur sicheren Abschaltung eines Photovoltaikmoduls mit mindestens einer Solarzellgruppe (VI, V2, V3), mit einem mit der mindestens einen Solarzellgruppe (VI, V2, V3) elektrisch in Verbindung stehenden ersten Leiter (2) und mit einem mit der mindestens einen Solarzellgruppe (V1, V2, V3) elektrisch in Verbindung stehenden zweiten Leiter (3), wobei die besagten Leiter über eine Anschlussvorrichtung die von der mindestens einen Solarzellgruppe (VI, V2, V3) erzeugte Spannung aus dem Photovoltaikmodul wegführen,
wobei eine Sicherheitsvorrichtung mindestens ein erstes Sicherheitsschaltelement (U) und ein zweites Sicherheitsschaltelement (T) umfasst, wobei die Sicherheitsschaltelemente (U, T) parallel über der mindestens einen Solarzellgruppe (V1, V2, V3) oder den Solarzellgruppen (V1, V2, V3) oder einer Reihe der Solarzellgruppen (VI, V2, V3) angeordnet sind und mit dem ersten Leiter (2) und dem zweiten Leiter (4) elektrisch leitend in Verbindung stehen,
wobei bei Eintritt eines Fehlerzustandes mindestens eines der Sicherheitsschaltelemente-(U, T) mit einem Schaltvorgang geschaltet wird, so dass über
der Solarzellgruppe bzw. den Solarzellgruppen (V1, V2, V3) ein Kurzschlusskreis entsteht, wodurch die Solarzellgruppe bzw. die Solarzellgruppen (V1, V2, V3) von der Anschlussvorrichtung abgeschaltet weiden, und
wobei die mindestens zwei Sicherheitsschaltelemente (U, T) den Schaltvorgang in bezuglich der Temperatur teilweise überlappenden und mindestens teilweise
unterschiedlichen Arbeitsbereichen (AU, AT) ausführen, wobei bezüglich der Temperatur jedem der Sicherheitsschaltelemente (U, T) ein definierter Arbeitsbereich (AU, AT) zugewiesen ist, wobei sich die Arbeitsbereiche (AU, AT) teilweise überlappen.

2. Verfahren nach Anspruch 1, **dadurch gekennzeichnet, dass** das erste Sicherheitsschaltelemente (U) den Schaltvorgang bis zu einer vorbestimmten
Temperatur (Tv) ausführt und dass das zweite Sicherheitsschaltelement (T) den Schaltvorgang über der vordefinierten Temperatur (Tv) ausführt, wobei die vordefinierte Temperatur (Tv) vorzugsweise im oberen Bereich des Arbeitsbereiches (AU) des ersten Sicherheitsschaltelementes (U) liegt.

3. Verfahren nach einem der vorhergehenden Ansprüche, **dadurch gekennzeichnet, dass** die Sicherheitsschaltelemente (U, T) bis zum Erreichen einer vordefinierten Grenztemperatur (GT) den besagten Schaltvorgang reversibel ausführen, so dass bei Wegfall des Fehlerzustandes die Sicherheitsschaltelement (U, T) derart geschaltet werden, dass der besagte Kurzschlusskreis unterbrochen wird.

4. Verfahren nach einem der vorhergehenden Ansprüche, **dadurch gekennzeichnet, dass** mindestens eines der Schaltelemente bei Überschreiten einer vordefinierten Grenztemperatur (GT) den Schaltvorgang irreversibel ausführt, so dass der Kurzschlusskreis auch nach dem Unterschreiten der Grenztemperatur (GT) besteht.

5. Verfahren nach einem der vorhergehenden Ansprüche, **dadurch gekennzeichnet, dass** mindestens eines der Sicherheitsschaltelemente (N, U) die Gestalt eines Halbleiterschaltelementes (N, U) aufweist und dass mindestens eines der Sicherheitsschaltelemente (T) die Gestalt eines elektromechanischen Relais aufweist, wobei unterhalb oder bis zu einer vorbestimmten Temperatur (Tv), welche bevorzugt unterhalb der maximalen Betriebstemperatur der Halbleiterschaltelemente (N. U) liegt, der besagte Schaltvorgang von allen Sicherheitsschaltelementen (N, U, T) gewährleistet wird, während oberhalb dieser vorbestimmten Temperatur (Tv) bzw. oberhalb der maximalen Betriebstemperatur der Halbleiterschaltelemente (N, U) besagte Schaltvorgang vom elektromechanischen Relais (T) gewährleistet wird.

6. Verfahren nach einem der vorhergehenden Ansprüche, **dadurch gekennzeichnet, dass** die Sicherheitsschaltelemente (U, T) bezüglich der Schaltung nach unterschiedlichen physikalischen Prinzipien ausgebildet sind.

7. Verfahren nach einem der vorhergehenden Ansprüche, **dadurch gekennzeichnet, dass** die Sicherheitsvorrichtung weiter eine Trennvorrichtung (P) umfasst, welche in Reihe zu der Solarzellgruppe bzw. den Solarzellgruppen (V1, V2, V3) angeordnet ist/sind, wodurch die Solarzellgruppe bzw. Solarzellgruppen (VI, V2, V3) von der Anschlussvorrichtung abgetrennt werden.

8. Sicherheitsvorrichtung zur Durchführung des Verfahrens nach einem der Ansprüche 1 bis 7, wobei die Sicherheitsvorrichtung mindestens ein erstes Sicherheitsschaltelement (U) und ein zweites Sicherheitsschaltelement (T) umfasst, wobei die Sicherheitsschaltelemente (U, T) parallel über der mindestens einen Solarzellgruppe (VI, V2, V3) oder den Solarzellgruppen (VI, V2, V3) oder einer Reihe der Solarzellgruppen (V1, V2, V3) angeordnet sind und mit dem ersten Leiter (2) und dem zweiten Leiter (4) elektrisch leitend in Verbindung stehen,
wobei bei Eintritt eines Fehlerzustandes mindestens eines der Sicherheitsschaltelemente (U, T) mit einem Schaltvorgang geschaltet wird, so dass über der Solarzellgruppe bzw. den Solarzellgruppen (VI, V2, V3) ein Kurzschlusskreis (K) hergestellt wird,
wobei der Schaltvorgang durch die mindestens zwei Sicherheitsschaltelemente (U, T) in bezüglich der Temperatur teilweise überlappenden und mindestens teilweise unterschiedlichen Arbeitsbereichen (AU, AT) ausgeführt wird
wobei bezüglich der Temperatur jedem der Sicherheitsschaltelemente (U, T) ein definierter Arbeitsbereich (AU, AT) zugewiesen ist, wobei sich die Arbeitsbereiche (AU, AT) teilweise überlappen.

9. Vorrichtung nach Anspruch 8, **dadurch gekennzeichnet, dass** eines der Sicherheitsschaltelemente (T) bei Überschreiten einer vordefinierten Temperatur (Tv) den Schaltvorgang ausführt, wobei die vordefinierte Temperatur ausserhalb des Arbeitsbereiches (AU) der anderen Sicherheitsschaltelemente (U) liegt, oder wobei die vordefinierte Temperatur (Tv) über dem Arbeitsbereich der anderen Schaltelemente (U) liegt.

10. Vorrichtung nach einem der Ansprüche 8 bis 9, **dadurch gekennzeichnet, dass** die Sicherheitsschaltelemente (U, T) bis zum Erreichen einer vordefinierten Grenztemperatur (GT) den besagten Schaltvorgang reversibel ausführen, so dass bei Wegfall des Fehlerzustandes die Sicherheitsschaltelement (U, T) derart geschaltet werden, dass der besagte Kurzschlusskreis unterbrochen wird, und/oder dass mindestens eines der Schaltelemente bei Überschreiten einer vordefinierten Grenztemperatur (GT) den Schaltvorgang irreversibel ausführt, so dass der Kurzschlüsskreis auch nach dem Unterschreiten der Grenztemperatur (GT) besteht.

11. Vorrichtung nach einem der Ansprüche 8 bis 10 dadurh gekennzeichnet, dass eines der mindestens zwei Schaltelemente ein Halbleiterschaltelement (U) ist, das den Schaltvorgang in einem Temperaturbereich von -50°C bis 175°C, insbesondere bis 125°C, besonders bevorzugt bis 85°Causführt, und dass eines der mindestens zwei Schaltelement ein elektromechanisches Relais (T) ist, das den Schaltvorgang in einem Temperaturbereich bis 500°C, insbesondere in einem Temperaturbereich von -50°C bis 500°C ausführt.

12. Vorrichtung nach einem der Ansprüche 8 bis 11, **dadurch gekennzeichnet, dass** mindestens eines der Sicherheitsschaltelemente (N, U) die Gestalt eines Halbleiterschaltelementes (N, U) aufweist und dass mindestens eines der Sicherheitsschaltelement (T) die Gestalt eines elektromechanischen Relais aufweist, wobei unterhalb oder bis zu einer vorbestimmten Temperatur, welche unterhalb der maximalen Betriebstemperatur der Halbleiterschaltelemente (N. U) liegt, der besagte Schaltvorgang von allen Sicherheitsschaltelementen (N, U, T) gewährleistet wird, während oberhalb dieser maximalen Betriebstemperatur der Halbleiterschaltelemente (N, U) besagte Schaltvorgang vom elektromechanischen Relais (T) gewährleistet wird.

13. Vorrichtung nach einem der Ansprüche 8 bis 12, **dadurch gekennzeichnet, dass** die Sicherheitsschaltelemente (U, T) bezüglich der Schaltung nach unterschiedlichen physikalischen Prinzipien ausgebildet sind.

14. Vorrichtüng nach einem der Ansprüchen 8 bis 13 **dadurch gekennzeichnet, dass** die Sicherheitsvorrichtung weiter eine Trennvorrichtung (P) umfasst, welche parallel über der mindestens einen Solarzellgruppe (VI, V2, V3) angeordnet ist, so dass über der mindestens einen Solarzellgruppe (VI, V2, V3) ein Kurzschlusskreis entsteht, wodurch die mindestens eine Solarzellgruppe (VI, V2, V3) von der Anschlussvorrichtung abgeschaltet wird.

15. Photovoltaikmodul zur Erzeugung von elektrischer Energie umfassend mindestens eine Solarzellgruppe (V1, V2, V3), mit einem mit der mindestens einen Solarzellgruppe (VI, V2, V3) elektrisch Verbindung stehenden ersten Leiter (2) und mit einem mit der Solarzellgruppe (VI, V2, V3) elektrisch in Verbindung stehenden zweiten Leiter (3), wobei die besagten Leiter (2, 3) über eine Anschlussvorrichtung (4, 5) mit elektrischen Verbrauchern in Verbindung steht, **dadurch gekennzeichnet**, das das Photovoltaikmodul weiter eine Anschlussdose umfasst, in welcher die Sicherheitsvorrichtung nach einem der Ansprüche 8 bis 14 angeordnet ist.

## Claims

1. A method for the safe disconnection of a photovoltaic module comprising at least one solar cell group (V1, V2, V3), comprising a first conductor (2), which is electrically connected to the at least one solar cell group (V1, V2, V3) and comprising a second conductor (3), which is electrically connected to the at least one solar cell group (V1, V2, V3), wherein said conductors, via a connection device, conduct the voltage generated by the at least one solar cell group (VI, V2, V3) away out of the photovoltaic module,
wherein the safety apparatus comprises at least a first safety switching element (U) and a second safety switching element (T), wherein the safety switching elements (U, T) are arranged in parallel across the at least one solar cell group (V1, V2, V3) or the solar cell groups (VI, V2, V3) or a series of solar cell groups (VI, V2, V3) and are electrically conductively connected to the first conductor (2) and the second conductor (4),
wherein, in the event of the onset of a fault state, at least one of the safety switching elements (U, T) is switched with a switching operation such that a short circuit is produced across the solar cell group or solar cell groups (V1, V2, V3), as a result of which the solar cell group or solar cell groups (V1, V2, V3) are disconnected from the connection device, and
wherein the at least two safety switching elements (U, T) implement the switching operation in working ranges (AU, AT) which, with respect to temperature, partially overlap one another and are at least partially different than one another.

2. The method as claimed in one of the preceding claims, **characterized in that** the first safety switching element (U) implements the switching operation up to a predetermined temperature (Tv), and **in that** the second safety switching element (T) implements the switching operation above the predefined temperature (Tv), wherein the predefined temperature (Tv) is preferably in the upper range of the working range (AU) of the first safety switching element (U).

3. The method as claimed in one of the preceding claims, **characterized in that** the safety switching elements (U, T) implement said switching operation reversibly until a predefined limit temperature (GT) is reached, with the result that, in the event of discontinuation of the fault state, the safety switching elements (U, T) are switched in such a way that said short circuit is interrupted.

4. The method as claimed in one of the preceding claims, **characterized in that** at least one of the switching elements implements the switching operation irreversibly in the event that a predefined limit temperature (GT) is exceeded, with the result that the short circuit is also present once the limit temperature (GT) has been undershot.

5. The method as claimed in one of the preceding claims, **characterized in that** at least one of the safety switching elements (N, U) has the configuration of a semiconductor switching element (N, U), and **in that** at least one of the safety switching elements (T) has the configuration of an electromechanical relay, wherein, below or up to a predetermined temperature (Tv), which is preferably below the maximum operating temperature of the semiconductor switching elements (N, U), said switching operation is ensured by all safety switching elements (N, U, T), while, above this predetermined temperature (Tv) or above the maximum operating temperature of the semiconductor switching elements (N, U), said switching operation is ensured by the electromechanical relay (T).

6. The method as claimed in one of the preceding claims, **characterized in that** the safety switching elements (U, T) are designed in accordance with different physical principles with respect to switching.

7. The method as claimed in one of the preceding claims, **characterized in that** the safety device furthermore comprises an isolating device (P), which is/are arranged in series with the solar cell group or solar cell groups (V1, V2, V3), as a result of which the solar cell group or solar cell groups (V1, V2, V3) are disconnected from the connection device.

8. A safety device for implementing the method as claimed in one of claims 1 to 7, wherein the safety device comprises at least a first safety switching element (U) and a second safety switching element (T), wherein the safety switching elements (U, T) are arranged in parallel across the at least one solar cell group (VI, V2, V3) or the solar cell groups (VI, V2, V3) or a series of solar cell groups (VI, V2, V3) and are electrically conductively connected to the first conductor (2) and the second conductor (4),
wherein, in the event of the onset of a fault state, at least one of the safety switching elements (U, T) is switched with a switching operation, with the result that a short circuit (K) is produced across the solar cell group or solar cell groups (VI, V2, V3),
wherein the switching operation is implemented by the at least two safety switching elements (U, T) in working ranges (AU, AT) which, with respect to temperature, partially overlap one another and are at least partially different than one another,
wherein with respect to temperature, a defined working range (AU, AT) is allocated to each of the safety switching elements (U, T), wherein the working ranges (AU, AT) partially overlap one another.

9. The device as claimed in claim 8, **characterized in that** one of the safety switching elements (T) implements the switching operation in the event that a predefined temperature (Tv) is exceeded, wherein the predefined temperature is outside the working range (AU) of the other safety switching elements (U), or wherein the predefined temperature (Tv) is above the working range of the other switching elements (U).

10. The device as claimed in one of claims 8 to 9, **characterized in that** the safety switching elements (U, T) implement said switching operation reversibly until a predefined limit temperature (GT) is reached, with the result that, in the event of discontinuation of the fault state, the safety switching elements (U, T) are switched in such a way that said short circuit is interrupted, and/or **in that** at least one of the switching elements implements the switching operation irreversibly in the event that a predefined limit temperature (GT) is exceeded, with the result that the short circuit is also present once the limit temperature (GT) has been undershot.

11. The device as claimed in one of claims 8 to 10, **characterized in that** one of the at least two switching elements is a semiconductor switching element (U), which implements the switching operation in a temperature range of from -50°C to 175°C, in particular up to 125°C, particularly preferably up to 85°C, and **in that** one of the at least two switching elements is an electromechanical relay (T), which implements the switching operation in a temperature range up to 500°C, in particular in a temperature range of from -50°C to 500°C.

12. The device as claimed in one of claims 8 to 11, **characterized in that** at least one of the safety switching elements (N, U) has the configuration of a semiconductor switching element (N, U), and **in that** at least one of the safety switching elements (T) has the configuration of an electromechanical relay, wherein, below or up to a predetermined temperature, which is below the maximum operating temperature of the semiconductor switching elements (N, U), said switching operation is ensured by all of the safety switching elements (N, U, T), while, above this maximum operating temperature of the semiconductor switching elements (N, U), said switching operation is ensured by the electromechanical relay (T).

13. The device as claimed in one of claims 8 to 12, **characterized in that** the safety switching elements (U, T) are designed in accordance with different physical principles with respect to switching.

14. The device as claimed in one of claims 8 to 13, **characterized in that** the safety device further comprises an isolating device (P), which is arranged in parallel across the at least one solar cell group (VI, V2, V3), with the result that a short circuit is produced via the at least one solar cell group (V1, V2, V3), as a result of which the at least one solar cell group (V1, V2, V3) is disconnected from the connection device.

15. A photovoltaic module for generating electrical energy comprising at least one solar cell group (VI, V2, V3), comprising a first conductor (2), which is electrically connected to the at least one solar cell group (VI, V2, V3), and comprising a second conductor (3), which is electrically connected to the solar cell group (VI, V2, V3), wherein said conductors (2, 3) are connected to electrical consumers via a connection device (4, 5), **characterized in that** the photovoltaic module further comprises a junction box, in which the safety device as claimed in one of claims 8 to 14 is arranged.

## Revendications

1. Un procédé pour la déconnexion sûre d'un module photovoltaïque comprenant au moins un groupe de cellules solaires (V1, V2, V3), comprenant un premier conducteur (2), qui est relié électriquement au groupe de cellules solaires (VI, V2, V3) et comprenant un deuxième conducteur (3), qui est relié électriquement à l'au moins un groupe de cellules solaires (VI, V2, V3), où lesdits conducteurs, par l'intermédiaire d'un dispositif de raccordement, conduisent le voltage généré par ledit au moins un groupe de cellules solaires (VI, V2, V3) loin hors du module photovoltaïque,
où le dispositif de sécurité comprend au moins un premier élément de commutation de sécurité (U) et un deuxième élément de commutation de de sécurité (T), où les éléments de commutation de sécurité (U, T) sont disposés en parallèle à travers l'au moins un groupe de cellules solaires (V1, V2, V3) ou les groupes de cellules solaires (VI, V2, V3) ou une série de groupes de cellules solaires (V1, V2, V3), et sont reliées électriquement conductivement au premier conducteur (2) et le deuxième conducteur (4),
où, dans le cas de l'apparition d'un état de défaut, au moins un des éléments de commutation de sécurité (U, T) est commuté d'une opération de commutation de telle sorte qu'un court-circuit est produit à travers le groupe de cellules solaires ou des groupes de cellules solaires (V1, V2, V3), à la suite duquel le groupe de cellules solaires ou des groupes de cellules solaires (VI, V2, V3) sont déconnectés du dispositif de connexion, et
où les au moins deux éléments de commutation de sécurité (U, T) mettent en oeuvre l'opération de commutation dans des plages de travail (AU, AT) qui, par rapport à la température, se chevauchent partiellement les uns les autres et sont au moins partiellement différents les uns des autres.

2. Le procédé selon l'une quelconque des revendications précédentes, **caractérisé en ce que** le premier élément de commutation de sécurité (U) met en oeuvre l'opération de commutation jusqu'à une température prédéterminée (Tv), et **en ce que** le deuxième élément de commutation de sécurité (T) met en oeuvre l'opération de commutation au-dessus de la température prédéterminée (Tv), où la température prédéterminée (Tv) est de préférence dans la gamme supérieure de la plage de travail (AU) du premier élément de commutation de sécurité (U).

3. Le procédé selon l'une quelconque des revendications précédentes, **caractérisé en ce que** les éléments de commutation de sécurité (U, T) mettent en oeuvre ladite opération de commutation de manière réversible jusqu'à une température limite prédéfinie (GT) est atteinte, avec le résultat que en cas d'interruption de l'état de défaut, les éléments de commutation de sécurité (U, T) sont commutées de manière que ledit court-circuit est interrompu.

4. Le procédé selon l'une des revendications précédentes, **caractérisé en ce qu'**au moins un des éléments de commutation met en oeuvre l'opération de commutation de façon irréversible dans le cas où une température limite prédéfinie (GT) est dépassée, avec le résultat que le court-circuit est également présent une fois que la température limite (GT) a été sous passée.

5. Le procédé selon l'une quelconque des revendications précédentes, **caractérisé en ce qu'**au moins l'un des éléments de commutation de sécurité (N, U) a la configuration d'un élément de commutation à semi-conducteurs (N, U) et **en ce qu'**au moins un des éléments de commutation de sécurité (T) présente la configuration d'un relais électromécanique, où, au-dessous ou à une température prédéterminée (Tv), qui est de préférence inférieure à la température maximale de fonctionnement des éléments de commutation à semi-conducteurs (N, U), ladite opération de commutation est assurée par tous les éléments de commutation de sécurité (N, U, T), tandis que, au-dessus de cette température prédéterminée (Tv) ou au-dessus de la température maximale de fonctionnement des éléments de commutation à semi-conducteurs (N, U), ladite opération de commutation est assurée par le relais électromécanique (T).

6. Le procédé selon l'une quelconque des revendications précédentes, **caractérisé en ce que** les éléments de commutation de sécurité (U, T) sont conçus conformément aux principes physiques différents en ce qui concerne la commutation.

7. Le procédé selon l'une quelconque des revendications précédentes, **caractérisé en ce que** le dispositif de sécurité comprend en outre un dispositif d'isolement (P), qui est/sont disposés en série avec le groupe de cellules solaires ou les groupes de cellules solaires (VI, V2, V3), à la suite duquel le groupe de cellules solaires ou les groupes de cellules solaires (VI, V2, V3) sont déconnectés du dispositif de connexion.

8. Un dispositif de sécurité pour la mise en oeuvre du procédé selon l'une quelconque des revendications 1 à 7, où le dispositif de sécurité comprend au moins un premier élément de commutation de sécurité (U) et un deuxième élément de commutation de de sécurité (T), où les éléments de commutation de sécurité (U, T) sont disposés en parallèle à travers l'au moins un groupe de cellules solaires (VI, V2, V3) ou les groupes de cellules solaires (VI, V2, V3) ou une série de groupes de cellules solaires (VI, V2, V3) et sont reliées électriquement conductivement au premier conducteur (2) et au deuxième conducteur (4),
où, dans le cas de l'apparition d'un état de défaut, au moins un des éléments de commutation de sécurité (U, T) est commuté d'une opération de commutation, avec le résultat qu'un court-circuit (K) est produite à travers le groupe de cellules solaires ou les groupes de cellules solaires (VI, V2, V3),
où l'opération de commutation est mis en oeuvre par au moins deux éléments de commutation de sécurité (U, T) dans les plages de travail (AU, AT) qui, par rapport à la température, se chevauchent partiellement les uns les autres et sont au moins partiellement différents les uns des autres,
où, par rapport à la température, une plage de travail définie (AU, AT) est attribuée à chacun des éléments de commutation de sécurité (U, T), où les plages de travail (AU, AT) se chevauchent partiellement les uns les autres.

9. Le dispositif selon la revendication 8, **caractérisé en ce que** l'un des éléments de commutation de sécurité (T) met en oeuvre l'opération de commutation dans le cas où une température prédéterminée (TV) est dépassé, où la température prédéterminée est en dehors de la plage de travail (AU) des autres éléments de commutation de sécurité (U), ou où la température prédéterminée (Tv) est supérieure à la plage de fonctionnement des autres éléments de commutation (U).

10. Le dispositif selon l'une des revendications 8 à 9, **caractérisé en ce que** les éléments de commutation de sécurité (U, T) mettent en oeuvre ladite opération de commutation de manière réversible jusqu'à une température limite prédéterminée (GT) est atteinte, avec le résultat que, en cas d'arrêt de l'état de défaut, les éléments de commutation de sécurité (U, T) sont commutées de manière à ce que ledit court-circuit est interrompu, et/ou **en ce qu'**au moins un des éléments de commutation met en oeuvre l'opération de commutation de façon irréversible dans le cas où un température limite prédéterminée (GT) est dépassée, avec le résultat que le court-circuit est également présent lorsque la température limite (GT) a été sous passée.

11. Le dispositif selon l'une quelconque des revendications 8 à 10, **caractérisé en ce qu'**un des au moins deux éléments de commutation est un élément de commutation à semi-conducteur (U), qui met en oeuvre l'opération de commutation dans une plage de températures de -50 °C à 175 °C, en particulier jusqu'à 125 °C, en particulier de préférence jusqu'à 85 °C, et **en ce que** l'un des au moins deux éléments de commutation est un relais électromécanique (T), qui met en oeuvre l'opération de commutation dans une plage de température jusqu'à 500 °C, en particulier dans une plage de températures de -50 °C à 500 °C.

12. Le dispositif selon l'une quelconque des revendications 8 à 11, **caractérisé en ce qu'**au moins un des éléments de commutation de sécurité (N, U) a la configuration d'un élément de commutation à semi-conducteurs (N, U) et **en ce qu'**au moins un des éléments de commutation de sécurité (T) présente la configuration d'un relais électromécanique, où, au-dessous ou à une température prédéterminée qui est inférieure à la température maximale de fonctionnement des éléments de commutation à semi-conducteurs (N, U), ladite opération de commutation est assurée par l'ensemble de tous les éléments de commutation de sécurité (N, U, T), tandis que, au-dessus de cette température maximale de fonctionnement des éléments de commutation à semi-conducteurs (N, P), ladite opération de commutation est assurée par le relais électromécanique (T).

13. Le dispositif selon l'une quelconque des revendications 8 à 12, **caractérisé en ce que** les éléments de commutation de sécurité (U, T) sont conçus conformément aux principes physiques différents en ce qui concerne la commutation.

14. Le dispositif selon l'une des revendications 8 à 13, **caractérisé en ce que** le dispositif de sécurité comprend en outre un dispositif d'isolement (P), qui est disposé en parallèle sur le au moins un groupe de cellules solaires (VI, V2, V3), avec le résultat qu'un court-circuit est produit par au moins un groupe de cellules solaires (VI, V2, V3), à la suite de quoi le au moins un groupe de cellules solaires (VI, V2, V3) est déconnectée du dispositif de connexion.

15. Un module photovoltaïque pour générer de l'énergie électrique comprenant au moins un groupement de cellules solaires (V1, V2, V3), comprenant un premier conducteur (2), qui est relié électriquement à l'au moins un groupe des cellules solaires (V1, V2, V3), et comprenant un deuxième conducteur (3), qui est relié électriquement au groupe de cellules solaires (V1, V2, V3), où lesdits conducteurs (2, 3) sont reliés à des consommateurs électriques via un dispositif de connexion (4, 5), **caractérisé en ce que** le panneau photovoltaïque comprend en outre un boîtier de jonction, dans lequel le dispositif de sécurité selon l'une des revendications 8 à 14 est disposé.
